# EUROPEAN PATENT APPLICATION

(11) **EP 4 357 668 A1**
(43) Date of publication of application: **24.04.2024**
(21) Application number: 23199653.9
(22) Date of filing: 26.09.2023
(51) Int. Cl.: F21V 8/00, H05K 1/02, G06F 3/02, H03K 17/00, B60K 35/00, B60K 35/10, B60K 35/20

(54) **DECORATION PLATE**

(30) Priority: 20.10.2022 TW 111139870
(71) Applicant: Pegatron Corporation, Taipei City 112 (TW)
(72) Inventor: KUO, Yu-Feng, 112 TAIPEI CITY (TW)
(74) Representative: Becker, Eberhard

(57) **Abstract**

A decoration plate (10, 10A, 10B, 10C, 10D) including a light guide substrate (100), a decorative film (200), and a circuit board assembly (20, 20A) is provided. The light guide substrate (100) has a first surface (100S1) and a second surface (100S2) disposed on opposite sides, and has a first groove (Gl) on the first surface (100S1). The decorative film (200) is disposed on the second surface (100S2) of the light guide substrate (100). The decorative film (200) defines an operating region (DR). The circuit board assembly (20, 20A) is disposed on the first surface (100S1). The circuit board assembly (20, 20A) includes a light-emitting element (300) and a touch sensing layer (400). The light-emitting element (300) is accommodated in the first groove (Gl). A position of the touch sensing layer (400) corresponds to a position of an orthogonal projection of the operating region (DR) on the first surface (100S1).

## Description

### BACKGROUND

### Technical Field

The disclosure relates to an optical plate, and in particular to a decoration plate.

### Description of Related Art

Generally, if a touch function is desired on a vehicle-mounted decoration plate, the structure and composition thereof have to include a surface pattern layer, a decoration plate substrate material, an optical adhesive layer, a touch sensing layer, an LED light guide layer or a light isolation chamber, a diffuser, and a printed circuit board. Before the LED lights up, a user can only see the surface pattern layer. When the LED lights up, the user can see a designed indicator light or pattern. A control function is realized through sensing the touch of the user. The LED goes to sleep after a period of inactivity, and the decoration plate is again a part of an integrated design that matches the interior pattern.

### SUMMARY

The disclosure provides a decoration plate, which can reduce the production cost by simplifying the structure and production process.

An embodiment of the disclosure provides a decoration plate, which includes a light guide substrate, a decorative film, and a circuit board assembly. The light guide substrate has a first surface and a second surface disposed on opposite sides, and has a first groove on the first surface. The decorative film is disposed on the second surface of the light guide substrate. The decorative film defines an operating region. The circuit board assembly is disposed on the first surface. The circuit board assembly includes a light-emitting element and a touch sensing layer. The light-emitting element is accommodated in the first groove. A position of the touch sensing layer corresponds to a position of an orthogonal projection of the operating region on the first surface, and attached to the first surface.

Based on the above, in the decoration plate of an embodiment of the disclosure, since the light guide substrate of the decoration plate already includes a light guide structure, the touch sensing layer may be disposed under the light guide substrate, it is not necessary to consider the transmittance of the first circuit board or the attaching problem between the touch sensing layer and the light guide substrate, so that the production process of the decoration plate is simplified.

### BRIEF DESCRIPTION OF THE DRAWINGS

FIG. 1 is a schematic diagram of a decoration plate according to the first embodiment of the disclosure.
FIG. 2 is a schematic diagram of a decoration plate according to the second embodiment of the disclosure.
FIG. 3 is a schematic diagram of a decoration plate according to the third embodiment of the disclosure.
FIG. 4 is a schematic diagram of a decoration plate according to the fourth embodiment of the disclosure.
FIG. 5 is a schematic diagram of a decoration plate according to the fifth embodiment of the disclosure.

### DESCRIPTION OF THE EMBODIMENTS

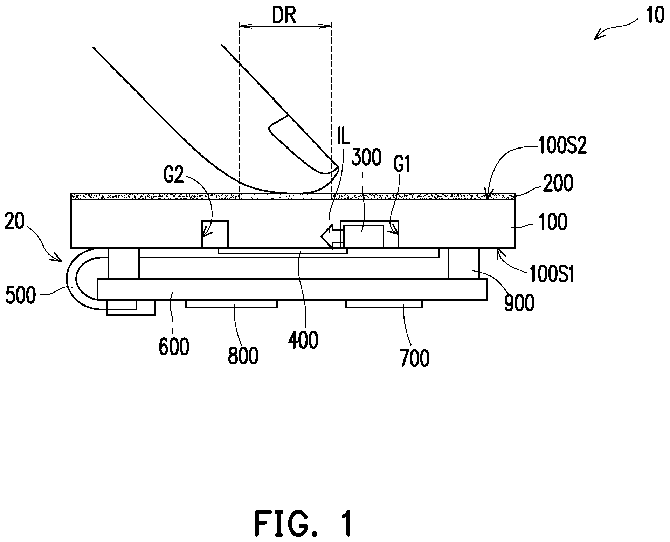

FIG. 1 is a schematic diagram of a decoration plate according to the first embodiment of the disclosure. For convenience of illustration, merely one operating region DR is shown in FIG. 1. Please refer to FIG. 1. An embodiment of the disclosure provides a decoration plate 10 including a light guide substrate 100, a decorative film 200, and a circuit board assembly 20.

In this embodiment, the light guide substrate 100 has a first surface 100S1 and a second surface 100S2 disposed on opposite sides, and has a first groove G1 on the first surface 100S1. The decorative film 200 is disposed on the second surface 100S2 of the light guide substrate 100. The decorative film 200 defines the operating region DR.

In this embodiment, the circuit board assembly 20 is disposed on the first surface 100S1. The circuit board assembly 20 includes at least a light-emitting element 300 and a touch sensing layer 400. The light-emitting element 300 is accommodated in the first groove G1. The light-emitting element 300 comprise, for example, one or more light-emitting diodes (LEDs) or other suitable light sources. The light-emitting element 300 is configured to emit a light beam IL, and the light beam IL may be red light, green light, blue light beam, or a combination thereof.

In this embodiment, a position of the touch sensing layer 400 corresponds to a position of the orthogonal projection of the operating region DR on the first surface 100S1.

In this embodiment, the operating region DR of the decorative film 200 has a light transmission property, so that the light beam IL emitted by the light-emitting element 300 may transmit the decorative film 200. In an embodiment, the decorative film 200 may have patterns in the operating region DR. After the light beam IL passes through the decorative film 200, the pattern on the decorative film 200 may be highlighted by lighting. In another embodiment, the decorative film 200 may not have the light transmission property or have a light absorbing property outside the operating region DR.

In this embodiment, the first surface 100S1 of the light guide substrate 100 has a second groove G2. A position of the second groove G2 separated from the position of the orthogonal projection of the operating region DR on the first surface 100S1 is opposite to the first groove G1 to reflect or absorb the light beam IL emitted by the light-emitting element 300. Taking FIG. 1 as an example, a surface of the second groove G2 adjacent to the first groove G1 is perpendicular to the first surface 100S1 to reflect the light beam IL transmitted to the second groove G2.

In this embodiment, the circuit board assembly 20 includes a first circuit board 500 and a second circuit board 600 connected to each other, a light source drive module 700, a touch drive module 800, and a column structure 900. The light-emitting element 300 and the touch sensing layer 400 are disposed on the first circuit board 500. The first circuit board 500 is disposed under the first surface 100S1, and the first circuit board 500 is attached to the first surface 100S1. The light source drive module 700 is disposed on the second circuit board 600 to drive the light-emitting element 300 to emit light. The touch drive module 800 is disposed on the second circuit board 600 to receive touch signals generated by the touch sensing layer 400. In addition, the column structure 900 is disposed between the light guide substrate 100 and the second circuit board 600 to fix the second circuit board 600, and the column structure 900 may also be a part of the light guide substrate 100.

In this embodiment, the first circuit board 500 is a flexible printed circuit board, and the second circuit board 600 is a printed circuit board. The light-emitting element 300 is directly formed on the first circuit board 500 by, for example, surface mount technology (SMT), or the sensing circuit may be directly designed on the first circuit board 500 to form the touch sensing layer 400.

Based on the above, in the decoration plate 10 according to an embodiment of the disclosure, the light guide substrate 100 has the first groove G1, and the light-emitting element 300 is accommodated in the first groove G1. The light guiding design of the substrate 100 simplifies the backlight structure and production process of the decoration plate 10, thus reducing the production cost of the decoration plate 10. Moreover, since the light guide substrate 100 of the decoration plate 10 already includes a light guide structure, the touch sensing layer 400 may be disposed under the light guide substrate 100, it is not necessary to consider the transmittance of the first circuit board 500 or the attaching problem between the touch sensing layer 400 and the light guide substrate 100, so that the production process of the decoration plate 10 is further simplified.

In addition, the first circuit board 500 of the decoration plate 10 of the embodiment of the disclosure may be a flexible printed circuit board. Therefore, in addition to a plane, the light guide substrate 100 may also be designed as a curved surface, so that the decoration plate 10 may be installed in different systems.

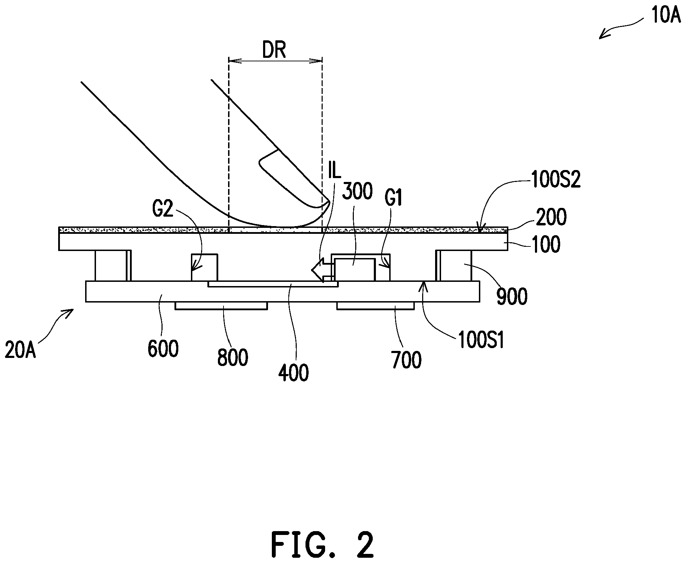

FIG. 2 is a schematic diagram of a decoration plate according to the second embodiment of the disclosure. Please refer to FIG. 2. A decoration plate 10A is similar to the decoration plate 10 in FIG. 1. The main difference is that, in this embodiment, a circuit board assembly 20A includes the printed circuit board 600, the light source drive module 700, the touch drive module 800, and the column structure 900. The light-emitting element 300 and the touch sensing layer 400 are disposed on a side of the printed circuit board 600, the light source drive module 700 is disposed on another side of the printed circuit board 600, and the touch drive module 800 is disposed on another side of the printed circuit board 600.

Based on the above, in the decoration plate 10A of an embodiment of the disclosure, since the touch sensing layer 400 is directly disposed on the printed circuit board 600 without using the flexible printed circuit board, the overall process is simplified, and the volume of the decoration plate 10A is further reduced. In addition, since the circuit board in the circuit board assembly 20A of the decoration plate 10A is the printed circuit board 600, in addition to a planar surface, the light guide substrate 100 may also be designed as a slightly curved surface, so that the decoration plate 10A has a slight curvature. The rest of the advantages of the decoration plate 10A in the embodiment of the disclosure are similar to the decoration plate 10, and will not be repeated here.

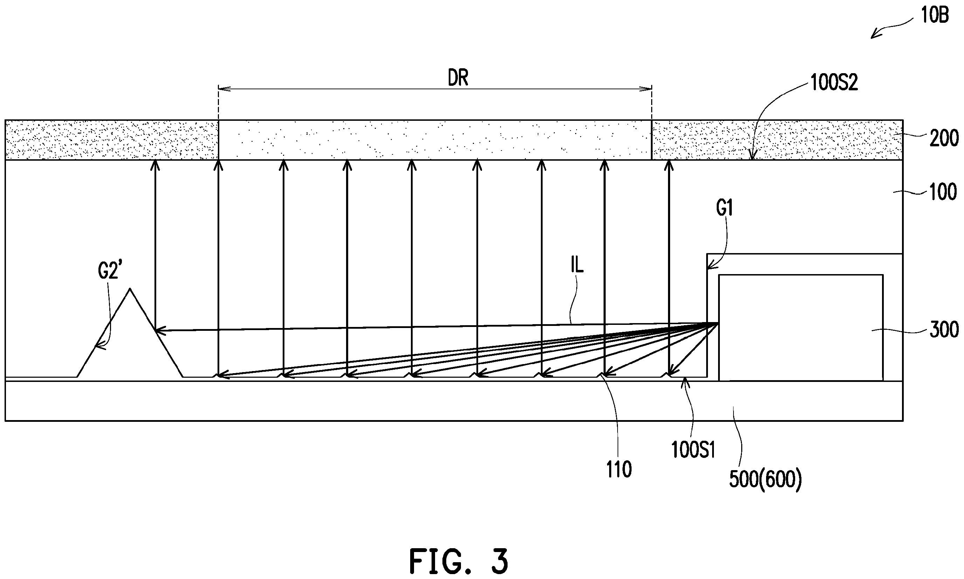

FIG. 3 is a schematic diagram of a decoration plate according to the third embodiment of the disclosure. For convenience of illustration, FIG. 3 does not completely show the circuit board assembly 20 or 20A in FIG. 1 or 2, but only briefly shows the first circuit boards 500 or the second circuit board/printed circuit board 600. Please refer to FIG. 3. A decoration plate 10B is similar to the decoration plate 10 in FIG. 1 or the decoration plate 10A in FIG. 2. The main difference is that, in this embodiment, the first surface 100S1 of the light guide substrate has a plurality of reflective microstructures 110. Positions of the reflective microstructures 110 correspond to the position of the orthogonal projection of the operating region DR on the first surface 100S1 so that the light beam IL emitted by the light-emitting element 300 is guided out of the light guide substrate 100. The distribution density of the reflective microstructures 110 is lower as getting closer to the first groove G1.

In this embodiment, a surface of a second groove G2' adjacent to the first groove G1 is an inclined surface with respect to the first surface 100S1.

Based on the above, in the decoration plate 10B of an embodiment of the disclosure, since the first surface 100S1 of the light guide substrate 100 has the plurality of reflective microstructures 110, the light beam IL concentrates on the operating region DR to emit light, so that the illumination brightness of the operating region DR is improved. Furthermore, the design that the distribution density of the reflective microstructures 110 being lower as getting closer to the first groove G1 helps improve the illumination uniformity of the operating region DR. The rest of the advantages of the decoration plate 10B in the embodiment of the disclosure are similar to the decoration plate 10 or 10A, and will not be repeated here.

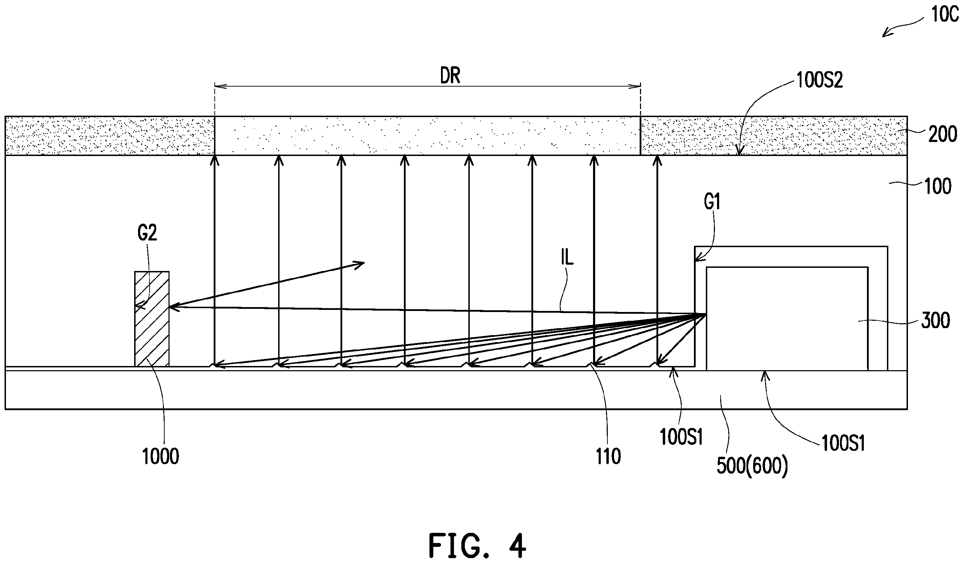

FIG. 4 is a schematic diagram of a decoration plate according to the fourth embodiment of the disclosure. For convenience of illustration, FIG. 4 does not completely show the circuit board assembly 20 or 20A in FIG. 1 or FIG. 2, but only briefly shows the first circuit boards 500 or the second circuit board/printed circuit board 600. Please refer to FIG. 4. A decoration plate 10C is similar to the decoration plate 10B in FIG. 3. The main difference is that, in this embodiment, the second groove G2 is filled with a light reflective material 1000 to reflect the light beam IL transmitted to the second groove G2. The rest of the advantages of the decoration plate 10C in the embodiment of the disclosure are similar to the decoration plate 10B, and will not be repeated here.

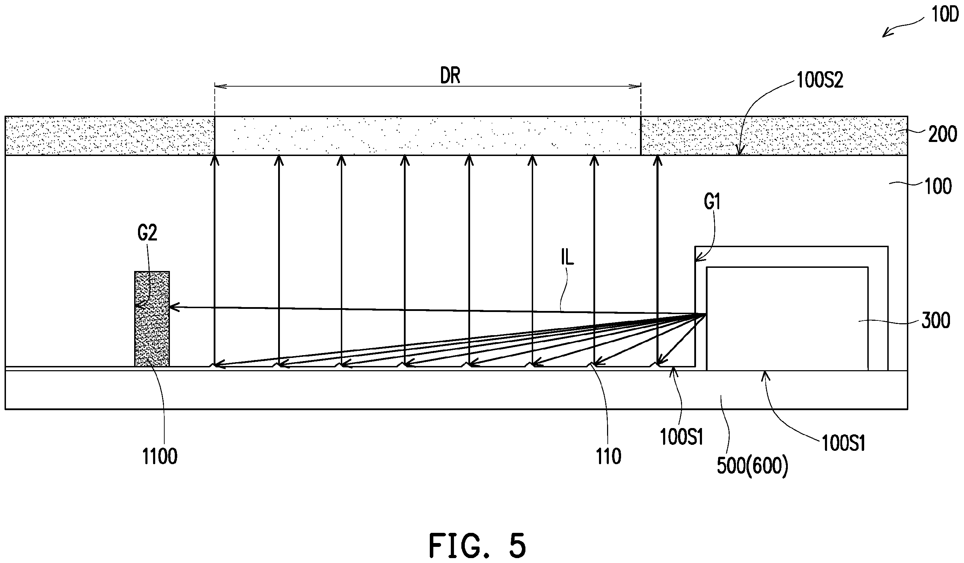

FIG. 5 is a schematic diagram of a decoration plate according to the fifth embodiment of the disclosure. For convenience of illustration, FIG. 5 does not completely show the circuit board assembly 20 or 20A in FIG. 1 or FIG. 2, but only briefly shows the first circuit boards 500 or the second circuit board/printed circuit board 600. Please refer to FIG. 5. A decoration plate 10D is similar to the decoration plate 10B in FIG. 3. The main difference is that, in this embodiment, the second groove G2 is filled with a light absorbing material 1100 to absorb the light beam IL transmitted to the second groove G2. The rest of the advantages of the decoration plate 10D in the embodiment of the disclosure are similar to the decoration plate 10B, and will not be repeated here.

In summary, in the decoration plate of an embodiment of the disclosure, the design of the light guide substrate having the light guiding property simplifies the backlight structure and production process of the decoration plate, thus reducing the production cost of the decoration plate. Moreover, since the light guide substrate of the decoration plate already includes a light guide structure, the touch sensing layer may be disposed under the light guide substrate, it is not necessary to consider the transmittance of the first circuit board or the attaching problem between the touch sensing layer and the light guide substrate, so that the production process of the decoration plate is further simplified.

## Claims

1. A decoration plate (10, 10A, 10B, 10C, 10D), comprising:
a light guide substrate (100) having a first surface (100S1) and a second surface (100S2) disposed on opposite sides, and having a first groove (G1) on the first surface (100S1);
a decorative film (200) disposed on the second surface (100S2) of the light guide substrate (100), wherein the decorative film (200) defines an operating region (DR); and
a circuit board assembly (20, 20A) disposed on the first surface (100S1), wherein the circuit board assembly (20, 20A) comprises a light-emitting element (300) and a touch sensing layer (400), the light-emitting element (300) is accommodated in the first groove (G1), and a position of the touch sensing layer (400) corresponds to a position of an orthogonal projection of the operating region (DR) on the first surface (100S1).

2. The decoration plate (10, 10A, 10B, 10C, 10D) as claimed in claim 1, wherein the operating region (DR) of the decorative film (200) has a light transmission property.

3. The decoration plate (10, 10A, 10B, 10C, 10D) as claimed in claim 1, the first surface (100S1) of the light guide substrate (100) has a plurality of reflective microstructures (110), and positions of the plurality of reflective microstructures (110) correspond to the position of the orthogonal projection of the operating region (DR) on the first surface (100S1) so that a light beam (IL) emitted by the light-emitting element (300) is guided out of the light guide substrate (100).

4. The decoration plate (10, 10A, 10B, 10C, 10D) as claimed in claim 3, wherein a distribution density of the plurality of reflective microstructures (110) is lower as getting closer to the first groove (G1).

5. The decoration plate (10, 10A, 10B, 10C, 10D) as claimed in claim 1, the first surface (100S1) of the light guide substrate (100) further has a second groove (G2), a position of the second groove (G2) separated from the position of the orthogonal projection of the operating region (DR) on the first surface (100S1) is opposite to the first groove (G1) to reflect or absorb a light beam (IL) emitted by the light-emitting element (300).

6. The decoration plate (10, 10A, 10C, 10D) as claimed in claim 5, wherein a surface of the second groove (G2) adjacent to the first groove (G1) is perpendicular to the first surface (100S1).

7. The decoration plate (10B) as claimed in claim 5, wherein a surface of the second groove (G2) adjacent to the first groove (G1) is an inclined surface with respect to the first surface (100S1).

8. The decoration plate (10C) as claimed in claim 5, wherein the second groove (G2) is filled with a light reflective material (1000).

9. The decoration plate (10D) as claimed in claim 5, wherein the second groove (G2) is filled with a light absorbing material (1100).

10. The decoration plate (10, 10B, 10C, 10D) as claimed in claim 1, the circuit board assembly (20) comprises:
a first circuit board (500) and a second circuit board (600) connected to each other, wherein the light-emitting element (300) and the touch sensing layer (400) are disposed on the first circuit board (500), and the first circuit board (500) is attached to the first surface (100S1);
a light source drive module (700) disposed on the second circuit board (600); and
a touch drive module (800) disposed on the second circuit board (600),
wherein the first circuit board (500) is a flexible printed circuit board, and the second circuit board (600) is a printed circuit board.

11. The decoration plate (10A) as claimed in claim 1, the circuit board assembly (20A) comprises:
a printed circuit board (600), wherein the light-emitting element (300) and the touch sensing layer (400) are disposed on a side of the printed circuit board (600);
a light source drive module (700) disposed on another side of the printed circuit board (600); and
a touch drive module (800) disposed on another side of the printed circuit board (600).
